# EUROPEAN PATENT APPLICATION

(11) **EP 1 617 192 A1**
(43) Date of publication of application: **18.01.2006**
(21) Application number: 05015073.9
(22) Date of filing: 12.07.2005
(51) Int. Cl.: G01J 1/46, G01J 1/32

(54) **Circuit detecting ambient light**

(30) Priority: 12.07.2004 JP 2004205255
(71) Applicant: SANYO ELECTRIC CO., LTD., Moriguchi-shi, Osaka 570-8677 (JP)
(72) Inventor: Ogawa, Takashi, Anpachi-gun Gifu, 503-0115 (JP)
(74) Representative: Glawe, Delfs, Moll

(57) **Abstract**

A detection circuit which converts an output current into a voltage is added to a photosensor (5) of a thin film transistor. Thereby, a very small current can be converted into a voltage in a desired range where a feedback can be provided. Since the circuit is composed of three TFTs and one capacitor, or of two TFTs (1, 2) and one capacitor (C), and one resistor (3), the number of parts can be reduced. The circuit is operated by simply inputting pulses at H level. Therefore, the easy light quantity detection circuit can be achieved.

## Description

### BACKGROUND OF THE INVENTION

### Field of the Invention

The present invention relates to a light quantity detection circuit of a photosensor, and more particularly to a light quantity detection circuit of a photosensor using a thin film transistor.

### Description of the Related Art

With regard to modern display devices, flat panel displays prevail in response to market demand for size reduction, weight reduction, and thinner shape. In many such display devices, photosensors are incorporated, the photosensor, for example, detecting the external light and controlling the brightness of the display screen.

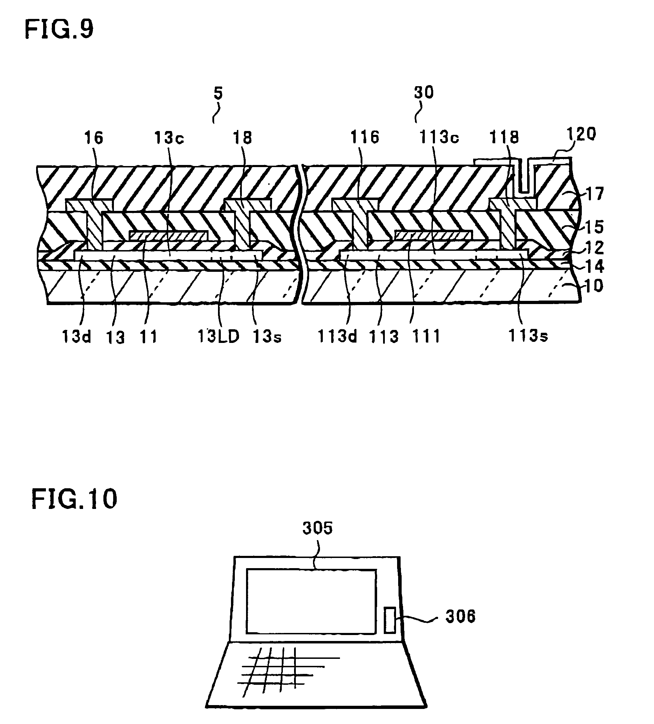

For example, Fig. 10 shows a display device, in which a photosensor 306 is integrated with a liquid crystal display (LCD) 305, and which controls the backlight brightness of the LCD screen in response to environmental light received. As the photosensor, a photoelectric conversion element of a CdS cell, for example, is used (see Japanese Patent Application Publication No. H06-11713, for example).

In addition, technologies of forming a photodiode by providing a semiconductor layer on the substrate of an LCD or an organic electro luminescence display (see Japanese Patent Application Publication No. 2002-176162, for example), and of utilizing a thin film transistor as a photosensor (see Japanese Patent Application Publication No. 2003-37261, for example), are also known.

The displays as shown in Fig. 10 are manufactured in such a manner that a display unit and a photosensor are fabricated as separate modules through separate manufacturing processes by use of separate plants. Thus, there have naturally been limits to reduction in the number of parts in the equipment and to reduction in the manufacturing cost of each module.

For this reason, technologies disclosed in the above-described JP2002-176162, which makes it possible to fabricate a display unit and a photosensor on the same substrate, are being developed. When a diode is used as a photosensor, leak current at reverse bias of the diode is detected as light quantity. In such a case, there are demands for achieving improvement in the photosensor characteristics and for life extension of the photosensor, by forcibly refreshing the photosensor at predetermined intervals.

However, in the case of the diode, since a gate electrode and a source (or a drain) are connected to each other, the gate electrode and the source are always at the same potential. That is, it is impossible to apply different voltages to the gate electrode and the source, respectively, and therefore to perform refresh. Moreover, in the case of a pn junction diode, there has been a problem that, since the leak characteristics during the time when light is not incident are unstable, the diode is not suitable for the photosensor.

In addition, a photosensor in which a thin film transistor is used and the leak current due to the light applied when the transistor is turned off is detected as light quantity, is known. However, the light quantity in this case is very small, and there has been a problem that feedback is difficult.

It is an object of this invention to provide a light quantity detection circuit that lessens these drawbacks.

### SUMMARY OF THE INVENTION

The solution according to the invention lies in the features of the independent claim and preferably in those of the dependent claims.

The invention provides a light quantity detection circuit that includes a photosensor having a thin film transistor and converting light incident thereon into an electric signal, a first power supply terminal supplying a high potential and a second power supply terminal supplying a low potential, a first switching transistor connected with the photosensor in series between the first power supply terminal and the second power supply terminal, a second switching transistor connected with a resistor in series between the first power supply terminal and the second power supply terminal, and a capacitor. The first capacitor terminal of the capacitor is connected with a control terminal of the second switching transistor, and a second capacitor terminal of the capacitor is connected with the first power supply terminal or the second power supply terminal.

With the present invention, first, a very small output current of the photosensor can be detected in such a manner that the current is converted (and amplified) into the voltage. In addition, the output voltage can be detected in binary. Moreover, an analog output can be performed by utilizing an integration area, for example. In other words, since the output voltage can be used as digital or analog, high versatility can be obtained by the embodiment of the present invention as the light quantity detection circuit.

Further, the number of parts can be reduced since the number of components in the circuit is small.

Second, since the switching transistor to configure a circuit can be a thin film transistor, it is possible to fabricate the light quantity detection circuit by use of a manufacturing process of a display device which employs a thin film transistor.

Third, since the resistor can be a thin film transistor in which a predetermined potential is applied to a control terminal thereof, it is possible to fabricate the light quantity detection circuit by use of the manufacturing process of the display device which employs a thin film transistor.

Fourth, since the output voltage can be changed by changing the potential which is applied to the control terminal of a thin film transistor to be a resistor, it is possible to adjust the sensitivity of the light quantity detection circuit due to change in potential.

Fifth, since the resistor can be formed out of a transparent electrode material, the light quantity detection circuit can be provided integrally by use of a manufacturing process of, for example, an LCD or an organic electro luminescence display, where a thin film transistor is employed.

Sixth, since the circuit can be operated by one pulse inputted to the first switching transistor, it is possible to convert the output current of the photosensor into voltage with an easy operation.

Seventh, since the photosensor can be directly irradiated with light to generate the photocurrent Ioff, the external light can be substantially directly detected by detecting the photocurrent Ioff.

Eighth, by adopting a LDD structure for the thin film transistor of the photosensor, it is possible to promote generation of the photocurrent Ioff. Especially, the LDD structure on the output side of the photocurrent Ioff will be effective to promote generation of the photocurrent Ioff. In addition, by adopting the LDD structure, the turn-off characteristics (a detection region) of Vg-Id characteristics is stabilized, and a stable device can be obtained.

### BRIEF DESCRIPTION OF THE DRAWINGS

Fig. 1 is a circuit schematic diagram showing a light quantity detection circuit of an embodiment of the present invention.
Fig. 2A is a cross-sectional view showing the structure of a photosensor of the first embodiment of the present invention.
Figs. 2B and 2C are characteristics diagrams showing Id-Vg curves of photosensors of the first embodiment of the present invention.
Fig. 3A is a timing chart explaining the light quantity detection circuit of the first embodiment of the present invention.
Figs. 3B and 3C are characteristics diagrams explaining the light quantity detection circuit of the first embodiment of the present invention.
Figs. 4A to 4C are characteristics diagrams explaining the light quantity detection circuit of the first embodiment of the present invention.
Figs. 5A to 5C are circuit schematic diagrams showing another configuration of the light quantity detection circuit of the first embodiment of the present invention.
Figs. 6A to 6D are circuit schematic diagrams showing another configuration of the light quantity detection circuit of the first embodiment of the present invention.
Fig. 7 is a circuit schematic diagram showing the light quantity detection circuit of a second embodiment of the present invention.
Fig. 8A is an exterior view explaining a display device using the light quantity detection circuit of a third embodiment of the present invention.
Fig. 8B is a detection flow chart explaining the display device using the light quantity detection circuit of the third embodiment of the present invention.
Fig. 9 is a cross-sectional view explaining the display device using the light quantity detection circuit of the third embodiment of the present invention.
Fig. 10 is a schematic diagram showing a conventional photosensor.

### DETAILED DESCRIPTION OF THE PREFERRED EMBODIMENTS

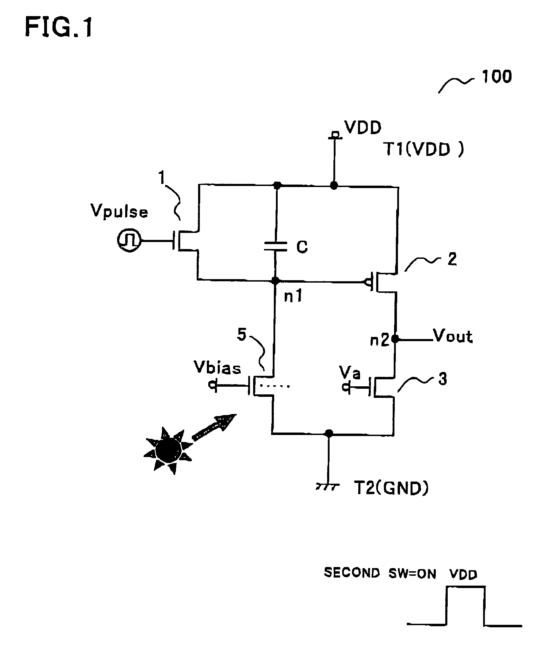

A detailed description will be given of the embodiments of the present invention with reference to Figs. 1 to 9.

Fig. 1 is a schematic diagram showing a light quantity detection circuit of a first embodiment.

A light quantity detection circuit 100 of this embodiment includes a photosensor 5, a capacitor C, a first switching transistor 1, a second switching transistor 2, a first connection point n1, a second connection point n2, a resistor 3, a first power supply terminal T1 and a second power supply terminal T2.

It is sufficient if the first power supply terminal T1 has a higher voltage than the second power supply terminal T2. In the embodiment, a description will be given, assuming that the first power supply terminal T1 is a VDD potential and the second power supply terminal T2 is a GND potential as an example.

The first switching transistor 1 is brought into conduction by use of an input of an input signal (voltage) Vpulse to a control terminal thereof. The first switching transistor 1 is connected in series to the photosensor 5. Both are connected between the first power supply terminal T1 and the second power supply terminal T2.

Further, the second switching transistor 2 and the resistor 3 are connected in series. These are also connected between the first power supply terminal T1 and the second power supply terminal T2.

One terminal of the capacitor C is connected to a control terminal of the second switching transistor 2 by use of the first connection point n1, and the other terminal is connected to the first power supply terminal T1 or the second power supply terminal T2. The capacitor C is charged by bringing the first switching transistor 1 into conduction. The potential of the first connection point n1 is thus changed.

Hereinafter, a description will be given in detail. The one terminal of the capacitor C is connected to an output terminal of the photosensor 5 by use of the first connection point n1, and the other terminal is connected to the first power supply terminal T1. The first switching transistor 1 is connected in parallel to the capacitor C. Pulses are inputted to the control terminal of the first switching transistor 1 for a certain period of time.

The second switching transistor 2 is connected in series between the first power supply terminal T1 and the second power supply terminal T2. The output from the first connection point n1 is applied to the control terminal of the second switching transistor 2. As an example, the first switching transistor 1 is an n-channel type thin film transistor (hereinafter referred to as TFT), and the second switching transistor 2 is a p-channel type TFT. Their structures are the same as that of the photosensor 5 described hereinafter.

One terminal of the resistor 3 is connected to one terminal of the second switching transistor 2 by use of the second connection point n2, and the other terminal is connected to the second power supply terminal T2 and is grounded. The resistor 3 is, for example, a p-channel type TFT, and a control terminal thereof is applied with a constant voltage Va. If the gate voltage va is fixed in a manner that a resistance between a source and drain of the TFT is high, it is possible to use the TFT as a resistance. Consequently, a photocurrent sensed at the photosensor 5 is converted into a voltage, which is then outputted from the second connection point n2. The voltage outputted due to a change in the constant voltage Va is changed, too. Note that a resistance value between the source and the drain is approximately 10³ Ω to 10⁸ Ω in this case.

In this manner, by connecting the resistor 3 having a high resistance value between the first power supply terminal T1 and the second power supply terminal T2, the photocurrent sensed at the photosensor 5 can be outputted as a divided voltage of a potential difference between a power supply potential VDD and a ground potential GND. A voltage between the first power supply terminal T1 and the second power supply terminal T2 may be set within a range where its use as a feedback is easy. Incidentally, a change of the constant voltage Va and a detail description of the circuit operation will be given later.

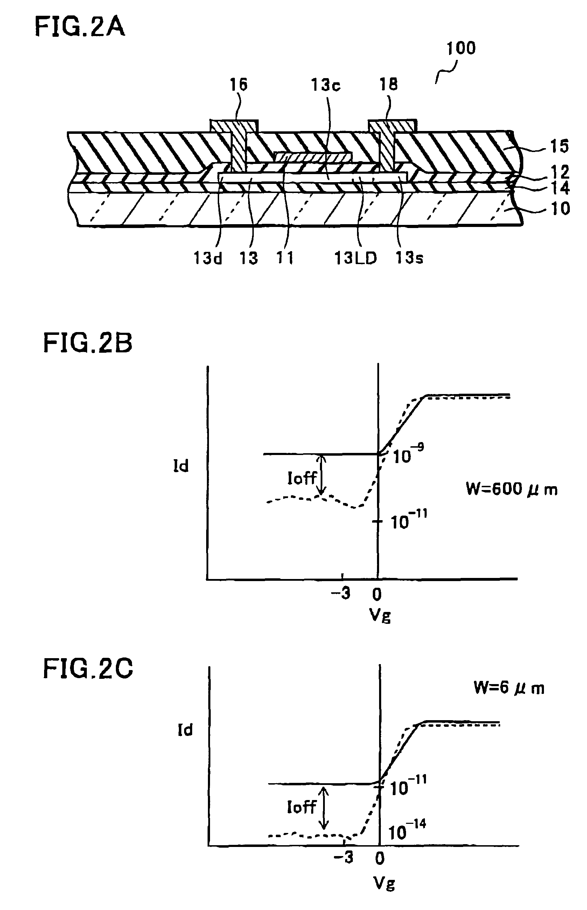

With reference to Figs. 2A to 2C, a description will be given of the photosensor 5 of this embodiment. Fig. 2A is a cross-sectional view showing the structure of the photosensor 5. Figs. 2B and 2C are diagrams showing current-voltage characteristics of a TFT to be the photosensor 5.

The photosensor 5 is composed of TFTs, each of which includes a gate electrode 11, an insulation film 12, and a semiconductor layer 13, as shown in Fig. 2A.

An insulation film (made of SiN, SiO₂ or the like) 14, which serves as a buffer layer, is provided on an insulating substrate 10 made of silica glass, no-alkali glass or the like, and thereon a semiconductor layer 13 made of a polycrystalline silicon (Poly-Silicon, hereinafter referred to as p-Si) film is laminated. This p-Si film may be formed by laminating an amorphous silicon film, and recrystallizing the film by laser annealing or the like.

On the semiconductor layer 13, the gate insulation film 12 made of SiN, SiO₂ or the like is laminated, and thereon the gate electrode 11 made of refractory metal, such as chrome (Cr), molybdenum (Mo) or the like, is formed.

In the semiconductor layer 13, an intrinsic or substantially intrinsic channel 13c which is located below the gate electrode 11 is provided. In addition, a source 13s and a drain 13d are provided which are n⁺ impurity diffusion regions on both sides of the channel 13c.

All over the gate insulation film 12 and the gate electrode 11, a SiO₂ film, a SiN film, and a SiO₂ film, for example, are sequentially laminated to form an interlayer insulation film 15. In the gate insulation film 12 and the interlayer insulation film 15, contact holes are provided, corresponding to the drain 13d and the source 13s. The contact holes are filled with metal, such as aluminum (Al) or the like, to provide a drain electrode 16 and a source electrode 18, which are brought into contact with the drain 13d and the source 13s, respectively.

In a p-Si TFT having a structure of this kind, when the TFT is off, if the external light enters the semiconductor layer 13, electron-hole pairs are generated in a junction region between the channel 13c and the source 13s or between the channel 13c and the drain 13d. These electron-hole pairs are separated due to the electric field in the junction region, thus generating photovoltaic force. Accordingly, the photocurrent is obtained, which is outputted from the source electrode 18 side, for example.

That is, by detecting the increase of this photocurrent (hereinafter referred to as photocurrent Ioff), a p-Si TFT with the above structure is used as a photosensor.

Here, the semiconductor layer 13 may be provided with a low concentration impurity region. The low concentration impurity region means a region which is provided adjacent to the source 13s or the drain 13d on the channel 13c side, and which is lower in impurity concentration compared to the source 13s or the drain 13d. By providing this region, it is made possible to relax the electric field concentrated at the edge of the source 13s (or the drain 13d). However, if the impurity concentration is excessively lowered, the electric field will increase. Moreover, the width of the low concentration impurity region (the length from the edge of the source 13s in the direction toward the channel 13c) also influences the electric field strength. That is, there exist optimal values of the impurity concentration of the low concentration impurity region and the width thereof. The optimal value of the width is approximately 0.5 µm to 3 µm, for example.

In this embodiment, a low concentration impurity region 13LD is provided, for example, between the channel 13c and the source 13s (or between the channel 13c and the drain 13d) to form a so-called light doped drain (LDD) structure. With the LDD structure, it is possible to increase, in the direction of a gate length L, the junction region contributing to the photocurrent Ioff generation, so that photocurrent Ioff generation occurs more readily. That is, it is advantageous that the low concentration impurity region 13LD is provided at least on the drain side in terms of the photocurrent Ioff. In addition, by adopting the LDD structure, the off characteristics (the detection region) of Vg-Id characteristics is stabilized, and a stable device can be obtained.

Figs. 2B and 2C show the Vg-Id curves of TFTs to be the photosensor 5. Fig. 2B is a diagram of the TFT with a gate width of 600 µm, and Fig. 2C is a diagram of the TFT with a gate width of 6 µm. In addition, both of the TFTs have a gate length L of 13 µm. These graphs show the cases where there is incident light (solid line) and where there is no incident light (broken line), on condition that, for example, n-channel type TFTs are used, and the drain voltage Vd and the source voltage Vs are 10 v and GND, respectively.

According to Figs. 2B and 2C, when the gate voltage Vg is equal to or lower than about -1V to 0V, the TFTs are turned off, and, when the gate voltage Vg exceeds the threshold voltage, the TFTs are turned on, and the drain current Id increases. When attention is focused on the vicinity of the gate voltage Vg = -3V at which the TFT is completely turned off, in the case of Fig. 2B, the drain current Id, which is approximately 1 x 10⁻¹¹ A when there is no incident light, increases up to approximately 1 x 10⁻⁹ A due to incidence of light. The drain current Id which increases due to the incident light is the photocurrent Ioff.

On the other hand, as shown in Fig. 2C, when the gate width W is small, the drain current Id, which is approximately 1 x 10⁻¹⁴ A when there is no incident light, becomes 1 x 10⁻¹¹ A due to incidence of light.

As described above, by adopting a large gate width w, it is possible to obtain a larger the photocurrent Ioff compared to the case of a smaller gate width W if the light quantity is equal.

It is possible to detect the current as the photocurrent Ioff in either case. However, with the current of the order of this level, it is difficult to provide feedback.

For this reason, this embodiment provides a circuit for reading a very small current of the above photosensor 5 as shown in Fig. 1, thereby making it possible to detect a sufficient quantity of light for feedback.

It should be noted that the photosensor 5 of the circuit shown in Fig. 1 is composed of one or more, and less than approximately 500 of TFTs described above. In a case where a plurality of TFTs are used, the gate electrodes 11 are made common, and the TFTs are connected to each other in parallel. In this embodiment, one hundred of TFTs are connected to each other in parallel as an example.

It should be noted that, in this embodiment, the first and second switching transistors 1 and 2 too are a TFT similar to that of the photosensor 5 of Fig. 2A. Moreover, it is preferable that the first and second switching transistors 1 and 2 also have a so-called LDD structure, because it is possible to relax the electric field concentrated at the edge of the source (or the drain).

In addition, the TFTs which are included in the light quantity detection circuit 100, except for the photosensor 5, may have a so-called top gate structure in which the gate electrode 11 is located in the upper layer of the semiconductor layer 13 as shown in Fig. 2A, or may have a bottom gate structure in which the gate electrode 11 is located in the lower layer of the semiconductor layer 13. If the TFTs other than the photosensor 5 have the top gate structure, it is advantageous to provide the TFTs with light shielding layers. For example, by disposing gate electrodes above and below the semiconductor layer 13, the gate electrode in the lower layer is used as the light shielding layer. In this case, the potential of the gate electrode, which serves as the shielding layer, can be a floating one, the same potential as that of the gate electrode in the upper layer, or a different potential therefrom, for example, the potential of the gate electrode in the lower layer being selected as appropriate according to the circuit configuration.

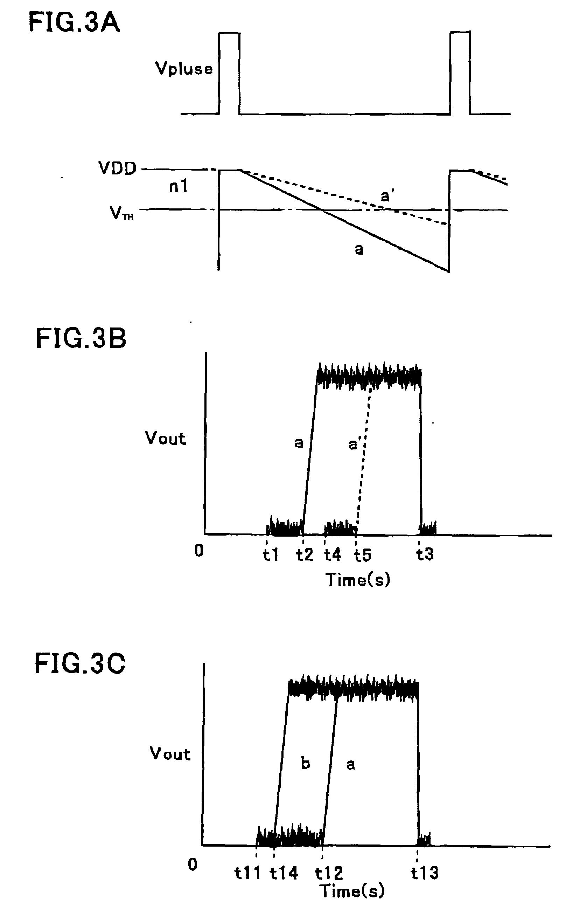

With reference to Figs. 1 and 3, a description will be given of the operation of the light quantity detection circuit 100. Fig. 3A is a timing chart and Figs. 3B and 3C are the examples of the output voltages Vout.

Pulses of a predetermined voltage Vpulse (H level) are inputted to the control terminal, that is, the gate electrode, of the first switching transistor 1 for a certain period of time. While the H level pulses are being inputted, the conduction of the first switching transistor 1 is maintained. Accordingly, the capacitor C is charged with electric charges of the power supply potential VDD.

When the pulses fall to L level (0 V), the first switching transistor 1 is cut off. In this embodiment, the standard potential (VDD potential) is set to be the potential of the first connection point n1, and the output voltage is obtained by causing the potential of the first connection point n1 to decrease due to the discharge from the photosensor 5.

When the photosensor 5 is irradiated with light, a very small the photocurrent Ioff of, for example, approximately 10⁻¹⁴ A to 10⁻⁹ A is outputted. As described above, the photocurrent Ioff is a dark current to be generated depending on light quantity irradiated when a TFT, which composes the photosensor 5, is off. In other words, a current leaking from the TFT composing the photosensor 5 due to light is sensed, thus detecting the light quantity. Therefore, if the photosensor 5 is irradiated with light, electric charges are discharged from the photosensor 5 depending on the light quantity, and the standard potential (VDD potential) of the first connection point n1 falls as shown in Fig. 3A with a solid line a.

The second switching transistor 2 is a p-channel type TFT, and a control terminal (gate electrode) thereof is connected to the first connection point n1. That is, if the potential of the first connection point n1 decreases to the threshold voltage VTH or under, the second switching transistor 2 is brought into conduction.

As long as the resistor 3 is a transistor, the resistor 3 is in conduction by use of the constant voltage Va, and a channel is formed depending on the constant voltage Va. Thus, it can be considered to be a resistor with a constant resistance value. The output voltage Vout is outputted by dividing the potential difference between the first power supply terminal T1 and the second power supply terminal T2 with the resistance values of the second switching transistor 2 and the resistor 3. In other words, before the second switching transistor 2 is brought into conduction, the resistance value of the second switching transistor 2 is sufficiently larger than that of the resistor 3, and the potential of the second connection point n2 thus draws closer to that of the second power supply terminal T2. To the contrary, after the second switching transistor 2 is brought into conduction, the resistance value of the second switching transistor 2 becomes sufficiently smaller than that of the resistor 3, and the potential of the second connection point n2 thus draws closer to that of the first power supply terminal T1.

Specifically, the photocurrent sensed at the photosensor 5 can be detected as the output voltage Vout whose value is close to that of the power supply potential VDD, by dividing the potential deference between the power supply potential VDD and the ground potential GND.

Here, since the resistance value of the resistor 3 is very high, it is possible to obtain the output voltage Vout whose value is reasonably large to the extent of providing a feedback easily even if the photocurrent is very small.

In this manner, the light quantity detection circuit 100 of the embodiment can be operated by simply inputting a pulse of the voltage Vpulse to the first switching transistor 1. Moreover, the light quantity detection circuit 100 can be also realized with the components of only three TFTs and one capacitor for the circuit formation. Thus, the number of parts can be reduced.

Figs. 3B and 3C show examples of outputting the output voltage Vout by use of light quantity. The x-axes in the graphs indicate time and the y-axes indicate the output voltages Vout. The solid line a and the dashed line a' show a case where the constant voltages Va of the resistor 3 are the same value, but light quantity detected at the photosensor 5 is different. The solid lines a and b show a case where the constant voltages Va of the resistor 3 differ from each other.

The relation between the light quantity, the value of the constant voltage Va (Va value) of the resistor 3 and the time for the output voltage Vout to be outputted becomes clear from these graphs.

First, with reference to Fig. 3B, descriptions will be given of a case (solid line a) where light quantity is larger and a case (dashed line a') where light quantity is smaller. In both cases, the Va values are the same.

As described above, the potential of the first connection point n1 increased to the standard potential VDD by use of the input signals (voltages) Vpulse decreases depending on light quantity sensed at the photosensor 5 (solid line a in Fig. 3A). Then, the potential of the first connection point n1 decreases to under the threshold voltage of the second switching transistor 2. When the second switching transistor 2 is turned on, a current flows from the first power supply terminal T1 to the resistor (TFT) 3 (t1 in Fig. 3B). The channel is formed in the TFT 3 depending on the gate voltage Va, and the current flowing to the TFT 3 reaches saturation after a predetermined period elapsed. For this reason, the resistor 3 comes to have a constant resistance value. At that time, as a divided voltage of the power supply potential VDD and the resistor 3, the output voltage Vout can be detected at the second connection point n2 (t2 in Fig.3B).

Further, after a certain period elapsed, if the voltage Vpulse is inputted to the first switching transistor 1, the second switching transistor 2 is turned off. Hence, the output voltage Vout is substantially 0 V (t3). In other words, the output voltage Vout can be detected in binary as a time during which the output voltage Vout is detected (H level) and a time during which the output voltage Vout is not detected (L level).

When the light quantity is small as shown with the dashed line a', the discharge amount from the photosensor 5 becomes small. Accordingly, the time for the dashed line a' to reach the threshold voltage of the second switching transistor 2 becomes later than that for the solid line a. That is, the timing for the second switching transistor 2 to be turned on becomes later (t4), and the timing for the output voltage Vout to reach H level becomes later (t5). The second switching transistor 2 is turned off by use of Vpluse inputted to the first switching transistor 1 at certain intervals. Then, the output voltage Vout falls to L level (t3). The time until the current flowing in the TFT 3 reaches saturation is substantially constant. Therefore, the delay for the second switching transistor 2 to be turned on indicates shortening the period during which the output voltage Vout stays H level.

Moreover, the longer the period to stay at H level is, the longer the time during which the output voltage Vout can be detected is. Accordingly, this means that the sensitivity as a photosensor is excellent. Therefore, the sensitivity of the light quantity detection circuit 100 of the embodiment can be changed depending on small or large light quantity (solid and dashed lines a and a').

Next, with reference to Fig. 3C, descriptions will be given of a case where the va value is large (solid line a) and a case where the Va value is small (solid line b). In both cases, the light quantity is the same.

As described above, the potential of the first connection point n1 is increased to the standard potential VDD by inputting the input signals (voltages) Vpulse decreases depending on the light quantity sensed at the photosensor 5 (solid line a in Fig. 3A). The potential of the first connection point n1 falls to under the threshold voltage of the second switching transistor 2, thus causing the second switching transistor 2 to be turned on. Then, the current flows from the first power supply terminal T1 to the resistor (TFT) 3 (t11 in Fig. 3C). The channel is formed in the TFT 3 depending on a larger gate voltage Val. After a certain period elapsed, the flowing current reaches saturation. For this reason, the resistor 3 comes to have a constant resistance value. At that time, as a divided voltage of the power supply potential VDD and the resistor 3, the output voltage Vout can be detected at the second connection point n2 (t12 in Fig. 3C).

After a certain period further elapsed, if the voltage Vpulse is inputted to the first switching transistor 1, the second switching transistor 2 is turned off. Hence, the output voltage Vout becomes substantially 0 V (t13). In other words, the output voltage Vout can be detected in binary as a time during which the output voltage Vout is detected (H level) and a time during which the output voltage Vout is not detected (L level).

As shown with the solid line b, when the Va value is small (va2), if the light quantity is the same, a time to reach the threshold voltage of the second switching transistor 2 is substantially the same as that of the solid line a. Therefore, timing for the second switching transistor 2 to be turned on is the same (t11).

When the second switching transistor 2 is turned on, the current flows from the first power supply terminal T1 to the resistor (TFT) 3. The channel is formed in the TFT3 depending on a lower gate voltage Va2. After a predetermined period elapsed, the flowing current reaches saturation. After that, the output voltage Vout can be detected by use of the divided voltage depending on the resistance value of the resistor 3 (t14).

After a certain period further elapsed, if the voltage Vpulse is inputted to the first switching transistor 1, the second switching transistor 2 is turned off. Hence, the output voltage Vout becomes substantially 0 v (t13 in Fig. 3C).

Here, if the gate voltage va2 is low, the channel width becomes narrow, too. Hence, timing when the current flowing in the TFT 3 reaches saturation becomes earlier in the case of the gate voltage Va2 than in the case of the gate voltage Val. Accordingly, timing to detect the output voltage Vout becomes earlier, thus extending a period to stay at H level (t12 to t14).

In other words, if the Va value is small, the sensitivity of the light quantity detection circuit 100 is improved, and also the sensitivity can be adjusted by a change in Va value.

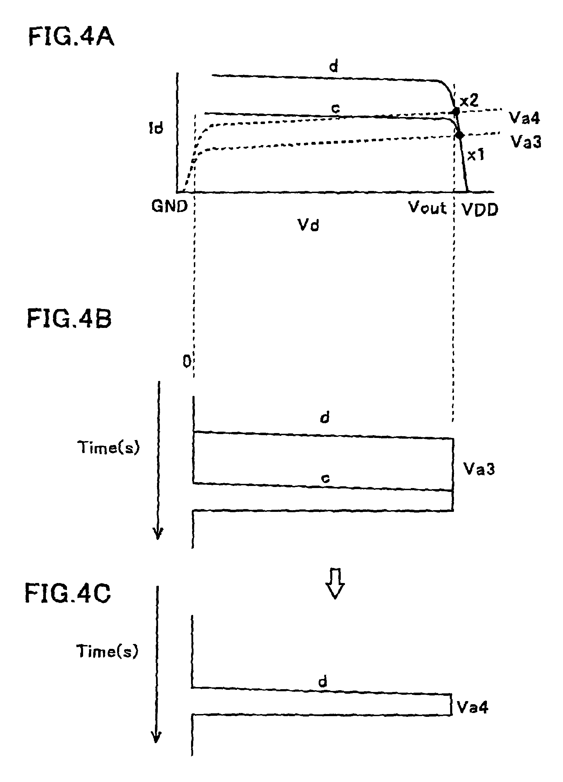

With reference to Figs. 4A to 4C, descriptions will be further given. Fig. 4A shows an example of the gate voltage Va of the TFT 3 and the Vd-Id characteristics of the second switching transistor 2. Solid lines c and d indicate the Vd-Id characteristics of the second switching transistor 2. The solid line c indicates a state to have a large light quantity while the solid line d indicates a state to have a small light quantity. In addition, dotted lines Va3 and Va4 indicate the Vd-Id characteristics of the TFT 3. The dotted line Va3 indicates a state to have a small gate voltage, and the dotted line Va4 indicates a state to have a large gate voltage. Moreover, Fig. 4B is a schematic diagram where the x-axis and y-axis of the output example of Fig. 3C are interchanged to correspond to Fig. 4A.

As shown in Figs. 4A and 4B, in the case of the gate voltage Va3, there is an intersection of the solid lines c and d, x1, in the linear region of the second switching transistor 2 (dotted line). Both the solid lines c and d can be detected as the output voltage Vout of H level. In the case of the solid line d, the output voltage Vout has a longer detection period than the solid line c.

On the other hand, as shown in Figs. 4A and 4C, if the gate voltage Va is excessively high (Va4), there is only the solid line d at an intersection x2 in the linear region of the second switching transistor 2 (dotted line). The solid line c shows that the output voltage Vout can not be detected since a saturation state at the resistor 3 brings a saturation state at the second switching transistor 2, too. In addition, the detection period of the solid line d is shortened.

Therefore, the voltage Vpulse and the gate voltage Va are selected suitably such that the Vd-Id curves of the TFT 3 intersect in the linear region of the second switching transistor 2.

In this manner, the binary output can be obtained by turning on and off the second switching transistor 2 in the light quantity detection circuit 100 in this embodiment. Therefore, the binary output can be utilized to determine whether the photosensor 5 is turned on or off at a certain timing.

Furthermore, by adjusting the gate voltage Va of the TFT 3 to be a resistor, the sensitivity of detecting the output voltage Vout of the light quantity detection circuit 100 of the embodiment can be changed.

Especially, since the photocurrent Ioff is a dark current of the TFT, variations in its values occur. However, the sensitivity of detecting the output voltage Vout can be adjusted by use of the gate voltage Va of the resistor 3, thus stabilizing the sensitivity of detecting light quantity in the plurality of light quantity detection circuits 100. Hence, it is possible to provide the light quantity detection circuits 100 with small variations of the performance thereof.

On the other hand, since it is also possible to output the output voltage Vout in analog by calculating the integration area, the light quantity detection circuit 100 can be utilized for a case where the light quantity at a certain timing is detected quantitatively. Thus, a highly versatile light quantity detection circuit 100 can be realized.

Moreover, with the above light quantity detection circuit 100, the detection sensitivity can be adjusted by use of not only the gate voltage Va value of the resistor 3 but the number of connections of the photosensor 5, the intervals for the input signals (voltages) vpulse or the capacitance of the capacitor C. The number of connections of the photosensor 5 contributes to the amount of the discharge of when external light is sensed, and the intervals of the input signals Vpulse contribute to the period during which the output voltage Vout stays at H level as shown in Figs. 3. Further, the capacitance of the capacitor C is a potential to be applied to the gate electrode of the second switching transistor 2, and the potential is changed by discharging the electric charges from the capacitor C due to the relation of V = Q/C. That is, the smaller capacitance of the capacitor C can make the detection sensitivity increase.

As described above, the description has been given of the light quantity detection circuit shown in Fig. 1 as an example. However, it should be understood that the light quantity detection circuit of this embodiment is not limited to such a configuration. Specifically, the light quantity detection circuit 100 with the following functions is sufficient: the first switching transistor 1 is brought into conduction; the potentials of the first and second power supply terminals T1 and T2 are charged with the potential of the first connection point n1; the first switching transistor 1 is interrupted; the potential of the first connection point n1 is changed by use of the discharge from the photosensor 5; the second switching transistor 2 is brought into conduction or is interrupted by use of the changed potential; and the output voltage Vout from the second connection point n2 of the second switching transistor 2 and the resistor 3 is detected.

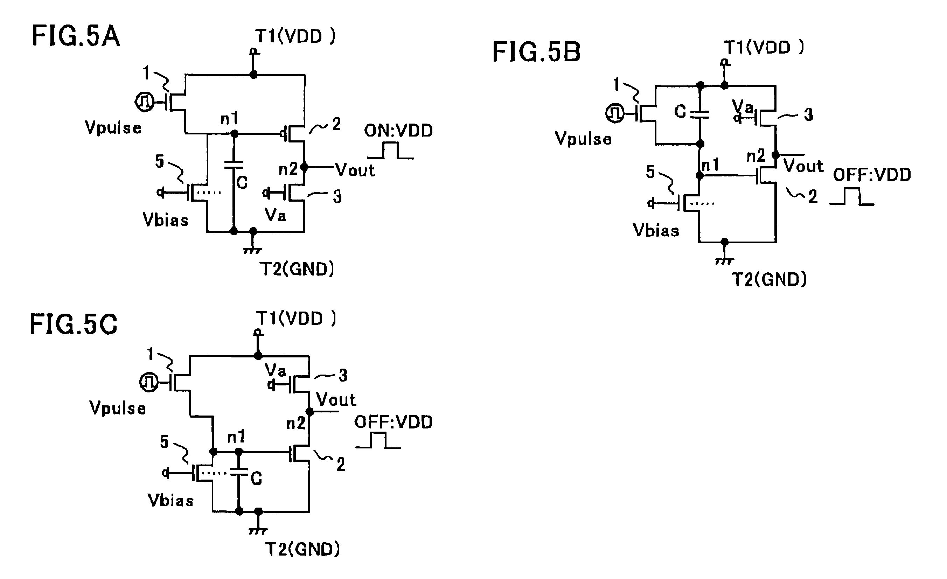

In Figs. 5A to 6D, another configuration of a light quantity detection circuit of the first embodiment is shown. First, Fig. 5 shows a circuit which can detect the output voltage Vout at a potential close to that of the first power supply potential VDD.

Fig. 5A: the first switching transistor 1 is connected in series to the photosensor 5, and is connected between the first power supply terminal T1 and the second power supply terminal T2. The second switching transistor 2 and the resistor 3 are connected in series, and they are also connected between the first power supply terminal T1 and the second power supply terminal T2. The second switching transistor 2 is a p-channel type TFT, and the resistor 3 is an n-channel type TFT. The capacitor C is connected in parallel to the photosensor 5. One terminal of the capacitor C is connected to the control terminal of the second switching transistor 2 through the first connection point n1, and the other terminal is connected to the second power supply terminal T2.

Pulses of a predetermined voltage Vpulse (H level) are inputted to the control terminal, that is, the gate electrode, of the first switching transistor 1 for a certain period of time. While the H level pulses are being inputted, the conduction of the first switching transistor 1 is maintained. With this, the capacitor C is charged with electric charges of the power supply potential VDD.

When the pulses fall to L level (0 V), the first switching transistor 1 is cut off. when the photosensor 5 is irradiated with light, the electric charges are discharged from the photosensor 5 depending on the light quantity, and the standard potential (VDD) of the first connection point n1 decreases.

The second switching transistor 2 is brought into conduction after the potential of the first connection point n1 falls to under the threshold voltage VTH. Therefore, the resistance value of the second switching transistor 2 becomes sufficiently smaller than that of the resistor 3, thus bringing the potential of the second connection point n2 close to that of the first power supply terminal T1. Specifically, by bringing the second switching transistor 2 into conduction, the output voltage Vout can be outputted at a potential close to the power supply potential VDD by use of the photocurrent detected at the photosensor 5 as a divided voltage of a potential difference between the power supply potential VDD and the ground potential GND.

Fig. 5B: the first switching transistor 1 is connected in series to the photosensor 5, and is connected between the first power supply terminal T1 and the second power supply terminal T2. The second switching transistor 2 and the resistor 3 are connected in series, and they are also connected between the first power supply terminal T1 and the second power supply terminal T2. The second switching transistor 2 is an n-channel type TFT, and the resistor 3 is also an n-channel type TFT. The capacitor C is connected in parallel to the first switching transistor 1. One terminal of the capacitor C is connected to the control terminal of the second switching transistor 2 through the first connection point n1, and the other terminal is connected to the first power supply terminal T1.

Pulses of a predetermined voltage Vpulse (H level) are inputted to the control terminal, that is, the gate electrode, of the first switching transistor 1 for a certain period of time. While the H level pulses are being inputted, the conduction of the first switching transistor 1 is maintained. With this, the capacitor C is charged with electric charges of the power supply potential VDD.

When the pulses fall to L level (0 V), the first switching transistor 1 is cut off. When the photosensor 5 is irradiated with light, the electric charges are discharged from the photosensor 5 depending on the light quantity, the standard potential (VDD) of the first connection point n1 decreases.

The second switching transistor 2 of an n-channel type TFT is in conduction from a time to start the conduction of the first switching transistor 1 to a time to reach the threshold voltage VTH by decreasing the potential of the first connection point n1. That is, while the second switching transistor 2 is in conduction, the resistance value of the second switching transistor 2 becomes sufficiently smaller than that of the resistor 3, thus bringing the potential of the second connection point n2 close to that of the second power supply terminal T2. On the other hand, when the potentihal falls to under the threshold voltage VTH, the second switching transistor 2 is cut off. Therefore, the resistance value of the second switching transistor 2 becomes sufficiently larger than that of the resistor 3, thus bringing the potential of the second connection point n2 close to that of the first power supply terminal T1. In other words, by cutting off the second switching transistor 2, the output voltage Vout can be outputted at a potential close to the power supply potential VDD by use of the photocurrent detected at the photosensor 5 as a divided voltage of a potential difference between the power supply potential VDD and the ground potential GND.

Fig. 5C: the first switching transistor 1 is connected in series to the photosensor 5, and is connected between the first power supply terminal T1 and the second power supply terminal T2. The second switching transistor 2 and the resistor 3 are connected in series, and they are also connected between the first power supply terminal T1 and the second power supply terminal T2. The second switching transistor 2 is an n-channel type TFT, and the resistor 3 is also an n-channel type TFT. The capacitor C is connected in parallel to the photosensor 5. One terminal of the capacitor C is connected to the control terminal of the second switching transistor 2 through the first connection point n1, and the other terminal is connected to the second power supply terminal T2.

Pulses of a predetermined voltage Vpulse (H level) are inputted to the control terminal, that is, the gate electrode, of the first switching transistor 1 for a certain period of time. While the H level pulses are being inputted, the conduction of the first switching transistor 1 is maintained. With this, the capacitor C is charged with electric charges of the power supply potential VDD.

When the pulses fall to L level (0 V), the first switching transistor 1 is cut off. When the photosensor 5 is irradiated with light, the electric charges are discharged from the photosensor 5 depending on the light quantity, the standard potential (VDD) of the first connection point n1 decreases.

The second switching transistor 2 of an n-channel type TFT is in conduction from a time to start the conduction of the first switching transistor 1 to a time to reach the threshold voltage VTH by decreasing the potential of the first connection point n1. That is, while the second switching transistor 2 is in conduction, the resistance value of the second switching transistor 2 becomes sufficiently smaller than that of the resistor 3, thus bringing the potential of the second connection point n2 close to that of the second power supply terminal T2. On the other hand, when the voltage falls to under the threshold voltage VTH, the second switching transistor 2 is cut off. Therefore, the resistance value of the second switching transistor 2 becomes sufficiently larger than that of the resistor 3, thus bringing the potential of the second connection point n2 close to that of the first power supply terminal T1. In other words, by cutting off the second switching transistor, the output voltage Vout can be detected at a potential close to the power supply potential VDD.

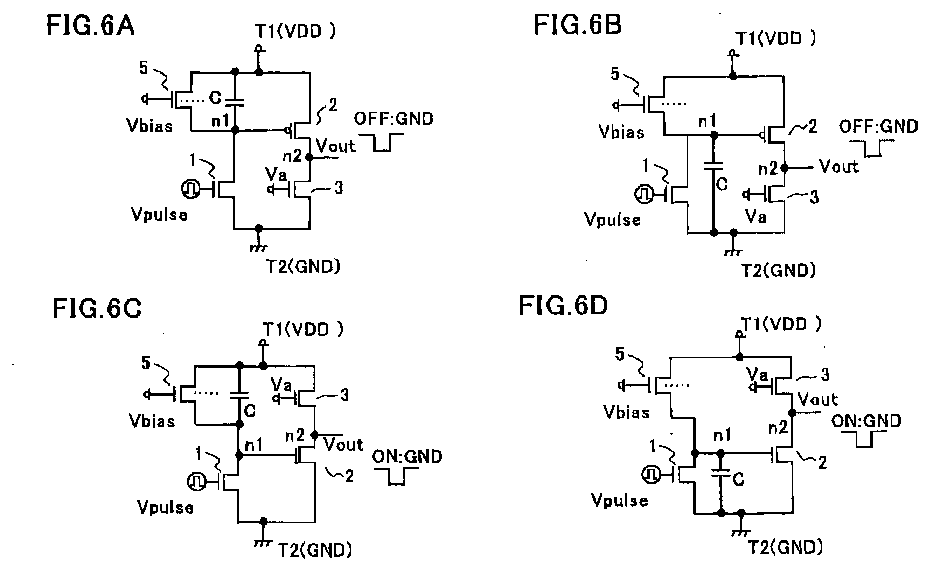

Figs. 6A to 6D show structures in which the connections of the first switching transistor 1 and the photosensor 5 of Figs. 1 and 5A to 5C are replaced. By use of this structure, the output voltage Vout can be detected at a potential close to that of the second power supply terminal T2.

Fig. 6A: the first switching transistor 1 is connected in series to the photosensor 5, and is connected between the first power supply terminal T1 and the second power supply terminal T2. The second switching transistor 2 and the resistor 3 are connected in series, and they are also connected between the first power supply terminal T1 and the second power supply terminal T2. The second switching transistor 2 is a p-channel type TFT, and the resistor 3 is an n-channel type TFT. The capacitor C is connected in parallel to the photosensor 5. One terminal of the capacitor C is connected to the control terminal of the second switching transistor 2 through the first connection point n1, and the other terminal is connected to the first power supply terminal T1.

Pulses of a predetermined voltage Vpulse (H level) are inputted to the control terminal, that is, the gate electrode, of the first switching transistor 1 for a certain period of time. While the H level pulses are being inputted, the conduction of the first switching transistor 1 is maintained. With this, the capacitor C is charged with electric charges of the ground potential GND.

When the pulses fall to L level (0 V), the first switching transistor 1 is cut off. when the photosensor 5 is irradiated with light, the electric charges are discharged from the photosensor 5 depending on the light quantity, the standard potential (GND) of the first connection point n1 increases.

The second switching transistor 2 of a p-channel type TFT is in conduction from a time to start the conduction of the first switching transistor 1 to a time to reach the threshold voltage VTH by decreasing the potential of the first connection point n1. Consequently, when the second switching transistor 2 is in conduction, the potential of the second connection point n2 draws close to that of the first power supply terminal T1. On the other hand, when the potential of the first connection point n1 rises to over the threshold voltage, the second switching transistor 2 is cut off. Therefore, the potential of the second connection point n2 draws close to that of the second power supply terminal T2. In other words, by cutting off the second switching transistor 2, the output voltage Vout can be detected at a potential close to the ground potential GND.

Fig. 6B: the first switching transistor 1 is connected in series to the photosensor 5, and is connected between the first power supply terminal T1 and the second power supply terminal T2. The second switching transistor 2 and the resistor 3 are connected in series, and they are also connected between the first power supply terminal T1 and the second power supply terminal T2. The second switching transistor 2 is a p-channel type TFT, and the resistor 3 is an n-channel type TFT. The capacitor C is connected in parallel to the first switching transistor 1. One terminal of the capacitor C is connected to the control terminal of the second switching transistor 2 through the first connection point n1, and the other terminal is connected to the second power supply terminal T2.

Pulses of a predetermined voltage Vpulse (H level) are inputted to the control terminal, that is, the gate electrode, of the first switching transistor 1 for a certain period of time. While the H level pulses are being inputted, the conduction of the first switching transistor 1 is maintained. With this, the capacitor C is charged with electric charges of the ground potential GND.

When the pulses fall to L level (0 V), the first switching transistor 1 is cut off. When the photosensor 5 is irradiated with light, the electric charges are discharged from the photosensor 5 depending on the light quantity, the standard potential (GND) of the first connection point n1 increases.

The second switching transistor 2 of a p-channel type TFT is in conduction from a time to start the conduction of the first switching transistor 1 to a time to reach the threshold voltage VTH by increasing the potential of the first connection point n1. Consequently, when the second switching transistor 2 is in conduction, the potential of the second connection point n2 draws close to that of the first power supply terminal T1. On the other hand, when the potential of the first connection point n1 rises to over the threshold voltage VTH, the second switching transistor 2 is cut off. Therefore, the potential of the second connection point n2 draws close to that of the second power supply terminal T2. In other words, by cutting off the second switching transistor 2, the output voltage Vout can be detected at a potential close to the ground potential GND.

Fig. 6C: the first switching transistor 1 is connected in series to the photosensor 5, and is connected between the first power supply terminal T1 and the second power supply terminal T2. The second switching transistor 2 and the resistor 3 are connected in series, and they are also connected between the first power supply terminal T1 and the second power supply terminal T2. The second switching transistor 2 is an n-channel type TFT, and the resistor 3 is also an n-channel type TFT. The capacitor C is connected in parallel to the photosensor 5. One terminal of the capacitor C is connected to the control terminal of the second switching transistor 2 through the first connection point n1, and the other terminal is connected to the first power supply terminal T1.

Pulses of a predetermined voltage Vpulse (H level) are inputted to the control terminal, that is, the gate electrode, of the first switching transistor 1 for a certain period of time. While the H level pulses are being inputted, the conduction of the first switching transistor 1 is maintained. With this, the capacitor C is charged with electric charges of the ground potential GND.

When the pulses fall to L level (0 V), the first switching transistor 1 is cut off. When the photosensor 5 is irradiated with light, the electric charges are discharged from the photosensor 5 depending on the light quantity, the standard potential (GND) of the first connection point n1 increases.

The second switching transistor 2 of an n-channel type TFT is being cut off until the potential of the first connection point n1 reaches the threshold voltage VTH, and when the potential rises to over the threshold voltage VTH, the second switching transistor 2 is brought into conduction. The potential of the second connection point n2 draws close to that of the first power supply terminal T1 while the second switching transistor 2 is being cut off. When the second switching transistor 2 is brought into conduction, the potential of the second connection point n2 draws closer to that of the second power supply terminal T2. In other words, the output voltage Vout can be outputted at a potential close to the ground potential GND by bringing the second switching transistor 2 into conduction.

Fig. 6D: the first switching transistor 1 is connected in series to the photosensor 5, and is connected between the first power supply terminal T1 and the second power supply terminal T2. The second switching transistor 2 and the resistor 3 are connected in series, and they are also connected between the first power supply terminal T1 and the second power supply terminal T2. The second switching transistor 2 is an n-channel type TFT, and the resistor 3 is also an n-channel type TFT. The capacitor C is connected in parallel to the first switching transistor 1. One terminal of the capacitor C is connected to the control terminal of the second switching transistor 2 through the first connection point n1, and the other terminal is connected to the second power supply terminal T2.

Pulses of a predetermined voltage Vpulse (H level) are inputted to the control terminal, that is, the gate electrode, of the first switching transistor 1 for a certain period of time. While the H level pulses are being inputted, the conduction of the first switching transistor 1 is maintained. With this, the capacitor C is charged with electric charges of the ground potential GND.

When the pulses fall to L level (0 V), the first switching transistor 1 is cut off. When the photosensor 5 is irradiated with light, the electric charges are discharged from the photosensor 5 depending on the light quantity, the standard potential (GND) of the first connection point n1 increases.

The second switching transistor 2 of an n-channel type TFT is being cut off until the potential of the first connection point n1 reaches the threshold voltage VTH, and when the potential rises to over the threshold voltage VTH, the second switching transistor 2 is brought into conduction. The potential of the second connection point n2 draws close to that of the first power supply terminal T1 while the second switching transistor 2 is being cut off. When the second switching transistor 2 is brought into conduction, the potential of the second connection point n2 draws closer to that of the second power supply terminal T2. In other words, the output voltage Vout can be outputted at a potential close to the ground potential GND by bringing the second switching transistor 2 into conduction.

As described above, the second switching transistor 2 in this embodiment uses a p-channel type TFT if one terminal of the second switching transistor 2 is connected to the first power supply terminal T1 with a high potential as shown in Fig. 1, 5A, 6A or 6B. To the contrary, the second switching transistor 2 uses an n-channel type TFT if one terminal of the second switching transistor 2 is connected to the second power supply terminal T2 with a low potential as shown in Fig. 5B, 5C, 6C or 6D.

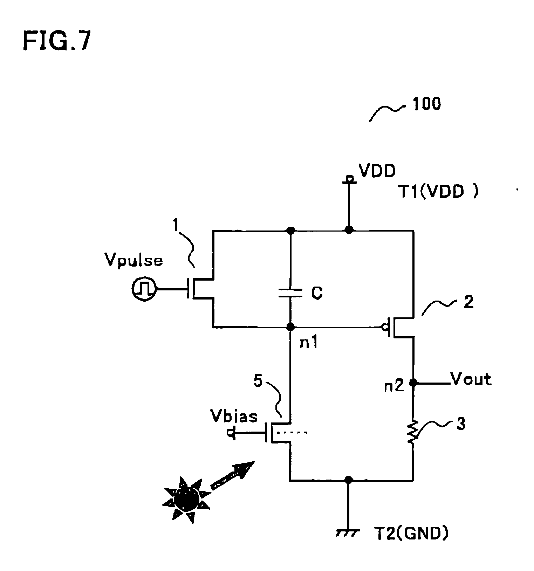

Fig. 7 shows a second embodiment of a light quantity detection circuit 100 and a case where a resistive element is connected as a resistor 3. Incidentally, the resistor 3 can be used as the resistive element in the light quantity detection circuits shown in Figs. 5A to 6D.

The resistive element is formed by doping p-Si, indium tin oxide (ITO) or the like with an n-type impurity, for example, and has a high resistance value of approximately 10³ Ω to 10⁸ Ω. Note that other components and circuit operations are similar to those of the circuit in Fig. 1. Therefore, the descriptions thereof will be omitted.

According to Fig. 7, by changing resistance values of the resistor 3, the condition becomes the same as a condition of when constant voltage Va is changed in the above-mentioned circuit. Thus, it is made possible to adjust the sensitivity of a photosensor 5.

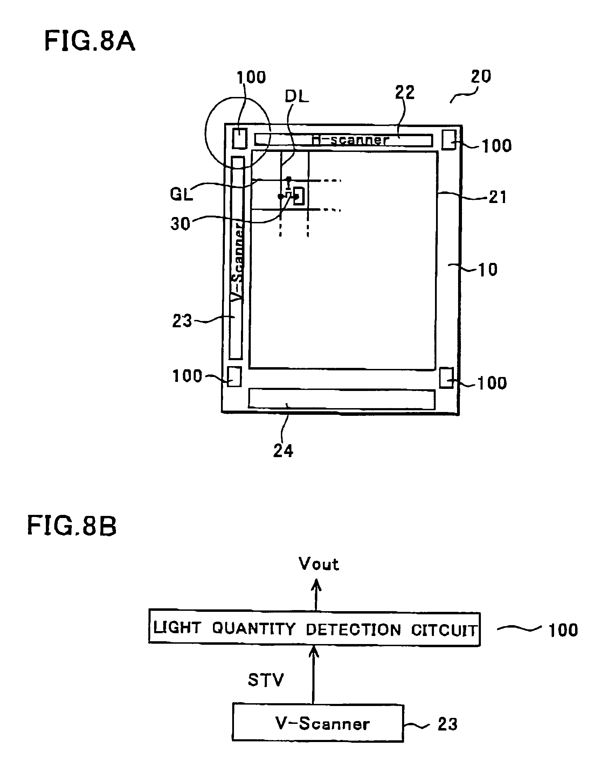

Figs. 8A to 9 show a third embodiment of this invention. A description will be given of an example of a case where a light quantity detection circuit 100 is fabricated on the substrate of an LCD or an organic electro luminescence display.

Fig. 8A is an example showing an exterior view of a display, and Fig. 8B is a diagram showing a detection flow of the light quantity detection circuit 100.

According to Fig. 8A, the light quantity detection circuit 100 of this embodiment is provided on the substrate of an LCD or an organic electro luminescence display device 20. The display device 20 has a display area 21 in which a plurality of display pixels 30 are disposed in a matrix arrangement on an insulating substrate 10, such as a glass plate. The light quantity detection circuits 100 are disposed at the four corners outside of the display area 21, for example.

On the substrate, a plurality of drain lines DL, and a plurality of gate lines GL are disposed, and the display pixels 30 are disposed, each corresponding to each of the intersections of the drain lines DL and the gate lines GL. Specifically, each of the display pixel 30 is connected to the source of a drive TFT, and the drain and the gate of the TFT are connected to the drain line DL and the gate line GL, respectively.

On sides of the display unit 21, a horizontal scanning circuit (hereinafter referred to as the H scanner) 22, which sequentially selects the drain lines DL, is disposed on one side thereof, and a vertical scanning circuit (hereinafter referred to as the V scanner) 23, which sends gate signals to the gate lines GL, is disposed on another side thereof. Further, unillustrated lines which transmit various signals inputted to the gate lines GL, the drain lines DL and the like are gathered to a side of the substrate 10, and are connected to an external connector 24.

The V scanner 23 selects the first gate line GL out of the plurality of gate lines GL following a vertical start signal STV to apply a gate voltage thereto. All of the TFTs connected to the gate lines GL to which the gate signals are applied are brought into a conduction state (ON).

During this period, the H scanner 22 selects the first drain line DL following a horizontal start signal STH at a predetermined timing. In this manner, the H scanner 22 sequentially selects a certain drain line DL out of the plurality of drain lines DL to supply signals to the display pixels 30, thus making the display pixels 30 located at intersections to emit light.

The v scanner 23 sequentially switches over to and selects the next gate line GL in response to a vertical clock CKV. The H scanner 22 sequentially switches over to and selects the next drain line DL in response to a horizontal clock CKH. In this manner, by sequentially scanning the gate lines GL and the drain lines DL, a predetermined image is displayed on the display area 21.

The vertical clock CKV and the horizontal clock CKH are generated by boosting the low voltage clock with an amplitude of 3V, for example, by use of a potential transformation circuit, the clock being outputted by an external control circuit.

In this embodiment, the vertical start signal STV of the V scanner 23 is inputted as a voltage Vpulse of a first switching transistor 1 (see Fig. 8B).

Fig. 9 is a cross-sectional view to explain a part of the light quantity detection circuit 100 (a photosensor 5) and a part of the display pixel 30.

The light quantity detection circuit 100 is provided on the substrate 10 on which the display pixels 30 are disposed, and can sense the light quantity equivalent to that in the display area 21. Moreover, light is directly incident onto the junction region between a source 13s and a channel 13c, or a drain 13d and the channel 13c of the photosensor 5. That is, the photosensor 5 directly receives the external light. Accordingly, it is made possible to sense the quantity of light which is incident onto the display area 21 and convert the light quantity into current by use of the photosensor 5, and to adjust the brightness of the display area 21, that is, for example, to control a controller. The controller allows the display area 21 to be bright outdoors or when the interior of a room is bright, or to exhibit a brightness corresponding to the environment when the environment is dark, in response to the amount of the output current (photocurrent Ioff) from the photosensor 5. That is, the brightness is made higher when the environment is bright, and is made lower when the environment is dark. In this manner, by automatically adjusting the brightness in response to the light quantity of the environment, it is possible to conserve electricity while the viewability is improved. Accordingly, by controlling the brightness by use of the light quantity detection circuit 100, especially in the display device 20 in which self-luminous elements, such as organic electro luminescence elements, are used, it is made possible to extend the life of light emitting elements.

As shown in Fig. 9, the light quantity detection circuit 100 and the display pixels 30 are provided on the same substrate. Incidentally, although in this figure, only the photosensor 5 of the light quantity detection circuit 100 is shown, the first switching transistor 1, a second switching transistor 2 and a TFT 3 to be a resistor has a similar structure to that of the photosensor 5.

The display pixel 30 also has a TFT having a similar structure to that of the photosensor 5. Specifically, an insulation film (made of SiN, SiO₂ or the like) 14, which serves as a buffer layer, is provided on the insulating substrate 10 made of silica glass, no-alkali glass or the like, and, on the top of the insulation film 14, a semiconductor layer 113 which is made of a p-Si film is deposited. The p-Si film may be formed by depositing an amorphous silicon film, and recrystallizing the film by laser annealing or the like.

On the semiconductor layer 113, a gate insulation film 12 made of SiN, SiO₂ or the like is deposited, and, on the top of the gate insulation film 12, a gate electrode 111 made of refractory metal, such as chrome (Cr), molybdenum (Mo) and the like, is formed.

In the semiconductor layer 113, an intrinsic, or substantially intrinsic, channel 113c which is located below the gate electrode 111 is provided. In addition, on both sides of the channel 113c, a source 113s and a drain 113d, which are n impurity diffusion regions, are provided.

All over the gate insulation film 12 and the gate electrode 111, an SiO₂ film, an SiN film, and an SiO₂ film, for example, are sequentially stacked to form an interlayer insulation film 15. In the gate insulation film 12 and the interlayer insulation film 15, contact holes are made, corresponding to the drain 113d and source 113s. The contact holes are filled with metal, such as aluminum (Al) and the like, to provide a drain electrode 116 and a source electrode 118, which are brought into contact with the drain 113d and the source 113s, respectively.

Incidentally, the photosensor 5 is similar to that of Fig. 2, and therefore description thereof is omitted. However, on the interlayer insulation film 15 of the photosensor 5 and the display pixel 30, a planarizing insulation film 17 for planarizing the display pixel 30 is formed.

In addition, a transparent electrode 120, which is made of indium tin oxide (ITO) or the like and serves as a display electrode (an anode), is provided to the display pixel 30 on the planarizing insulation film 17. The transparent electrode 120 is connected to the source electrode 118 (or the drain electrode 116) through a contact hole made in the planarizing insulation film 17. Note that although the illustration is omitted, an organic electroluminescent layer (an electron transport layer, a luminescence layer, and a hole transport layer) and a cathode are formed on the transparent electrode 120 to be the display pixel 30.

As described above, according to this embodiment, by using a manufacturing process of the display device 20 which is formed by providing thin film transistors on a substrate, it is possible to fabricate the light quantity detection circuit 100 on the same substrate.

Incidentally, in the case where the resistor 3 is formed of a resistive element as shown in Fig. 7, it is advantageous to form the resistor 3 out of a transparent electrode material such as ITO, or p-Si doped with an n-type impurity, for example. In this case, among others, p-Si doped with impurities is deteriorated due to exposure to light, and the resistance value becomes small. For this reason, in such a case, it is advantageous to provide light shielding over the resistor 3. In the LCD or the organic electro luminescence display device 20, since a shielding plate (not shown) is employed on the display area 21 in which the display pixels 30 are disposed, it is possible to provide light shielding over the resistor 3 by patterning the shielding plate.

It should be noted that, although the description has been given of the case of the TFT having the so-called top gate structure in this embodiment, the present invention can be similarly implemented with TFTs having a bottom gate structure in which the stacking order of a gate electrode 11, the gate insulation film 12 and a semiconductor layer 13 is inverted.

## Claims

1. A light quantity detection circuit comprising:
- a photosensor (5) comprising a thin film transistor and converting light incident thereon into an electric signal;
- a first power supply terminal (T1) supplying a high potential and a second power supply terminal (T2) supplying a low potential;
- a first switching transistor (1) connected with the photosensor (5) in series between the first power supply terminal (T1) and the second power supply terminal (T2);
- a second switching transistor (2) connected with a resistor (3) in series between the first power supply terminal (T1) and the second power supply terminal (T2); and
- a capacitor (C), a first capacitor terminal of the capacitor (C) being connected with a control terminal of the second switching transistor (2) and a second capacitor terminal of the capacitor (C) being connected with the first power supply terminal (T1) or the second power supply terminal (T2).

2. The light quantity detection circuit of claim 1, wherein the first switching transistor (2) is configured to turn on so that the first capacitor terminal is charged to the high potential or the low potential and to turn off so that the potential charged to the first capacitor terminal is changed when the thin film transistor of the photosensor (5) becomes conductive sensing the light incident thereon, and the second switching transistor (2) is configured to turn on or off upon the potential change at the first capacitor terminal so that an output voltage of the detection circuit is generated by dividing a potential difference between the high and low potentials among the resistor (3) and the second switching transistor (2).

3. The light quantity detection circuit of claim 1 or 2, wherein the second switching transistor (2) is of a p-channel type when the second switching transistor (2) is connected between the first power supply terminal (T1) and the resistor (3) and of an n-channel type when the second switching transistor (2) is connected between the second power supply terminal (T2) and the resistor (3).

4. The light quantity detection circuit according to any of claims 1 to 3, wherein each of the first and second switching transistors (1, 2) comprises a thin film transistor.

5. The light quantity detection circuit of claim 1, wherein the resistor (3) comprises a thin film transistor receiving a constant voltage at a control terminal thereof.

6. The light quantity detection circuit of claim 2, wherein the resistor (3) comprises a thin film transistor receiving a predetermined voltage at a control terminal thereof, and the predetermined voltage is adjusted to change a sensitivity of detecting the output voltage.

7. The light quantity detection circuit of claim 1, wherein the resistor (3) is made of a resistive material and has a resistance of approximately 10³ Ω to 10⁸ Ω.

8. The light quantity detection circuit of claim 2, wherein the resistor (3) is made of a resistive material and has a resistance value of approximately 10 Ω to 10⁸ Ω, and the resistance is adjusted to change a sensitivity of detecting the output voltage.

9. The light quantity detection circuit according to any of claims 1 to 8, wherein pulses are inputted to the first switching transistor (1) for a predetermined period of time, and the potential of the first capacitor terminal is reset to the high potential or the low potential.

10. The light quantity detection circuit according to any of claims 1 to 9, wherein the thin film transistor of the photosensor (5) comprises a semiconductor layer (13) comprising a source (13s), a drain (13d) and a channel (13c) disposed between the source (13s) and the drain (13d), and the semiconductor layer (13) is configured to receive light in a junction region between the channel (13c) and the source (13s) or the drain (13d) to generate a photocurrent.

11. The light quantity detection circuit according to any of claims 1 to 9, wherein the thin film transistor of the photosensor (5) comprises a semiconductor layer (113) comprising a source (13s), a drain (13d) and a channel (13c) disposed between the source (13s) and the drain (13d), and a low concentration impurity region (13LD) is disposed between the channel (13c) and the source (13s) or the drain (13d).

12. The light quantity detection circuit of claim 11, wherein the low concentration impurity region (13LD) is disposed on an output side of a photocurrent which is generated due to the incident light.
